# EUROPÄISCHE PATENTANMELDUNG

(11) **EP 0 969 532 A2**
(43) Veröffentlichungstag der Anmeldung: **05.01.2000**
(21) Anmeldenummer: 99111856.3
(22) Anmeldetag: 21.06.1999
(51) Int. Cl.: H01L 51/20, H01L 51/30, C09K 11/06

(54) **Elektrolumineszierende Anordnungen unter Verwendung von Azomethin-Metallkomplexen**

(30) Priorität: 04.07.1998 DE 19829948
(71) Anmelder: Bayer Aktiengesellschaft, 51368 Leverkusen (DE)
(72) Erfinder: Heuer, Helmut-Werner, Dr., 47829 Krefeld (DE); Wehrmann, Rolf, Dr., 47800 Krefeld (DE); Elschner, Andreas, Dr., 45479 Mülheim (DE)

(57) **Zusammenfassung**

Elektrolumineszierende Anordnung, aufgebaut aus einem Substrat, einer Anode, einem elektrolumineszierenden Element und einer Kathode, wobei wenigstens eine der beiden Elektroden im sichtbaren Spektralbereich transparent ist und das elektrolumineszierende Element eine oder mehrere Zonen aus der Gruppe der lochinjizierenden Zone, lochtransportierende Zone, elektrolumineszierenden Zone, elektronentransportierenden Zone und elektroneninjizierenden Zone in der genannten Reihenfolge enthält, wobei jede der vorhandenen Zonen auch Aufgaben der anderen genannten Zonen übernehmen kann, dadurch gekennzeichnet, daß das elektrolumineszierende Element einen Azomethin-Metallkomplex enthält.

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht rekombinieren.

Bei der Entwicklung lichtemittierender Bauteile für Elektronik oder Photonik kommen heute hauptsächlich anorganische Halbleiter, wie Galliumarsenid, zum Einsatz. Auf Basis derartiger Substanzen können punktförmige Anzeigeelemente hergestellt werden. Großflächige Anordnungen sind nicht möglich.

Neben den Halbleiterleuchtdioden sind elektrolumineszierende Anordnungen auf Basis aufgedampfter niedermolekularer organischer Verbindungen bekannt (US-A 4 539 507, US-A 4 769 262, US-A 5 077 142, EP-A 0 406 762, EP-A 0 278 758, EP-A 0 278 757).

Weiterhin werden Polymere, wie Poly-(p-phenylene) und Poly-(p-phenylenvinylene) (PPV) als elektrolumineszierende Polymere beschrieben: G. Leising et al., Adv. Mater. 4 (1992) No. 1; Friend et al., J. Chem. Soc., Chem. Commun. 32 (1992); Saito et al., Polymer, 1990, Vol. 31, 1137; Friend et al., Physical Review B, Vol. 42, No. 18, 11670 oder WO 90/13148. Weitere Beispiele für PPV in Elektrolumineszenzanzeigen werden in EP-A 0 443 861, WO-A 92/03490 und 92/03491 beschrieben.

EP-A 0 294 061 stellt einen optischen Modulator auf Basis von Polyacetylen vor.

Zur Herstellung flexibler Polymer-LEDs haben Heeger et al. lösliche konjugierte PPV-Derivate vorgeschlagen (WO-A 92/16023).

Polymerblends unterschiedlicher Zusammensetzung sind ebenfalls bekannt: M. Stolka et al., Pure & Appt. Chem., Vol. 67, No. 1, pp 175-182, 1995; H. Bässler et al., Adv. Mater. 1995, 7, No. 6, 551; K. Nagai et al., Appl. Phys. Lett. 67 (16), 1995, 2281; EP-A 0 532 798.

Die organischen EL-Anordnungen enthalten in der Regel eine oder mehrere Schichten aus organischen Ladungstransportverbindungen. Der prinzipielle Aufbau in der Reihenfolge der Schichten ist wie folgt:
1 Träger, Substrat
2 Basiselektrode
3 Löcher-injizierende Schicht
4 Löcher-transportierende Schicht
5 Licht-emittierende Schicht
6 Elektronen-transportierende Schicht
7 Elektronen-injizierende Schicht
8 Topelektrode
9 Kontakte
10 Umhüllung, Verkapselung.

Die Schichten 3 bis 7 stellen das elektrolumineszierende Element dar.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordung aus zwei Elektroden, zwischen denen sich eine organische Schicht befindet, die alle Funktionen - inklusive der der Emission von Licht - erfüllt. Derartige Systeme sind z.B. in der Anmeldung WO-A 90/13148 aufder Basis von Poly-(p-phenylenvinylen) beschrieben.

Der Aufbau von Mehrschichtsystemen kann durch Aufdampfverfahren, bei denen die Schichten sukzessive aus der Gasphase aufgebracht werden oder durch Gießverfahren erfolgen. Gießverfahren sind aufgrund der höheren Prozeßgeschwindigkeiten bevorzugt. Allerdings kann der Anlöseprozeß einer bereits aufgebrachten Schicht beim Überschichten mit der nächsten Schicht in bestimmten Fällen eine Schwierigkeit darstellen.

Die Aufgabe der vorliegenden Erfindung ist die Bereitstellung von elektrolumineszierenden Anordnungen mit hoher Leuchtdichte, wobei neuartige Metallkomplexe mit verbesserter Löslichkeit in gängigen Lösungsmitteln als Emitter und/oder Elektronleiter verwendet werden sollen. Diese neuartigen Metallkomplexe sollen auch durch Aufdampfverfahren aus der Gasphase aufgebracht werden können.

Es wurde gefunden, daß elektrolumineszierende Anordnungen, die untengenannte Metallkomplexe enthalten, diese Anforderungen erfüllen. Im folgenden ist der Begriff Zone auch mit Schicht gleichzusetzen.

Gegenstand der vorliegenden Erfindung sind daher elektrolumineszierende Anordnung, aufgebaut aus einem Substrat, einer Anode, einem elektrolumineszierenden Element und einer Kathode, wobei wenigstens eine der beiden Elektroden im sichtbaren Spektralbereich transparent ist und das elektrolumineszierende Element eine der oder mehrere Zonen aus der Gruppe der lochinjizierenden Zone, lochtransportierenden Zone, elektrolumineszierenden Zone, elektronentransportierenden Zone und elektroneninjizierenden Zone in der genannten Reihenfolge enthält, wobei jede der vorhandenen Zonen auch Aufgaben der anderen genannten Zonen übernehmen kann, dadurch gekennzeichnet, daß das elektrolumineszierende Element einen Azomethin-Metallkomplex enthält.

Die lochinjizierende Zone enthält vorzugsweise ein neutrales oder kationisches Polythiophen der Formel (I) 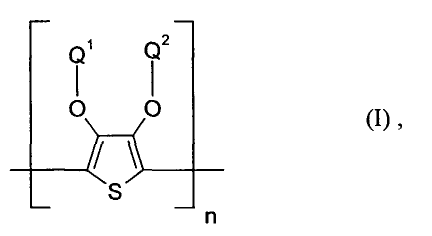 wobei
- Q¹ und Q²: unabhängig voneinander für Wasserstoff, gegebenenfalls substituiertes (C₁-C₂₀)-Alkyl, CH₂OH oder (C₆-C₁₄)-Aryl stehen oder
- Q¹ und Q²: zusammen -(CH₂)ₘ-CH₂- mit m = 0 bis 12, vorzugsweise 1 bis 5, (C₆-C₁₄)-Arylen bedeuten, und
- n: für eine ganze Zahl von 2 bis 10 000, vorzugsweise 5 bis 5 000 steht.

Die an die lochinjizierende Zone angrenzende lochleitende Zone enthält vorzugsweise eine oder mehrere aromatische tertiäre Aminoverbindungen, bevorzugt gegebenenfalls substituierte Triphenylaminverbindungen, besonders bevorzugt Tris-1,3,5-(aminophenyl)benzolverbindungen der Formel (II).

Die sich zwischen lochinjizierender Zone und Kathode befindlichen Zonen oder Zone können auch mehrere Funktionen übernehmen, d.h., daß eine Zone z.B. lochinjizierende, lochtransportierende, elektrolumineszierende, elektronentransportierende und/oder elektroneninjizierende Substanzen enthalten kann.

Das elektrolumineszierende Element kann ferner einen oder mehrere transparente polymere Binder enthalten.

Die gegebenenfalls substituierte Tris-1,3,5-(aminophenyl)benzol-Verbindung steht vorzugsweise für eine aromatische tertiäre Aminoverbindung der allgemeinen Formel (II) 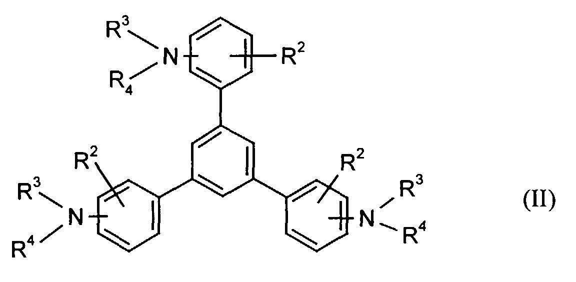 in welcher
- R²: für Wasserstoff, gegebenenfalls substituiertes Alkyl oder Halogen steht,
- R³ und R⁴: unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Aralkyl oder Cycloalkyl stehen.
- R³ und R⁴: stehen unabhängig voneinander bevorzugt für (C₁-C₆)-Alkyl, insbesondere Methyl, Ethyl, n- oder iso-Propyl, n-, iso-, sec.- oder tert.-Butyl, (C₁-C₄)-Alkoxycarbonyl-(C₁-C₆)-alkyl, wie beispielsweise Methoxy-, Ethoxy-, Propoxy-, Butoxycarbonyl-(C₁-C₄)-alkyl, jeweils gegebenenfalls durch (C₁-C₄)-Alkyl und/oder (C₁-C₄)-Alkoxy substituiertes Phenyl-(C₁-C₄)-alkyl, Naphthyl-(C₁-C₄)alkyl, Cyclopentyl, Cyclohexyl, Phenyl oder Naphthyl.

Besonders bevorzugt stehen R³ und R⁴ unabhängig voneinander für unsubstituiertes Phenyl oder Naphthyl oder jeweils einfach bis dreifach durch Methyl, Ethyl, n-, iso-Propyl, Methoxy, Ethoxy, n- und/oder iso-Propoxy substituiertes Phenyl oder Naphthyl.

R² steht vorzugsweise für Wasserstoff, (C₁-C₆)-Alkyl, wie beispielsweise Methyl, Ethyl, n- oder iso-Propyl, n-, iso-, sec.- oder tert.-Butyl, oder Chlor.

Derartige Verbindungen und deren Herstellung sind in US-A 4 923 774 für den Einsatz in der Elektrophotographie beschrieben, welche hiermit ausdrücklich als Bestandteil der Beschreibung aufgenommen wird ("incorporated by reference"). Die Tris-Nitrophenyl-Verbindung kann beispielsweise durch allgemein bekannte katalytische Hydrierung beispielweise in Gegenwart von Raney-Nickel in die Tris-aminophenyl-Verbindung überführt werden (Houben-Weyl 4/1C, 14-102, Ullmann (4) 13, 135-148). Die Aminoverbindung wird in allgemein bekannter Weise mit substituierten Halogenbenzolen umgesetzt.

Beispielhaft seien folgende Verbindungen genannt:

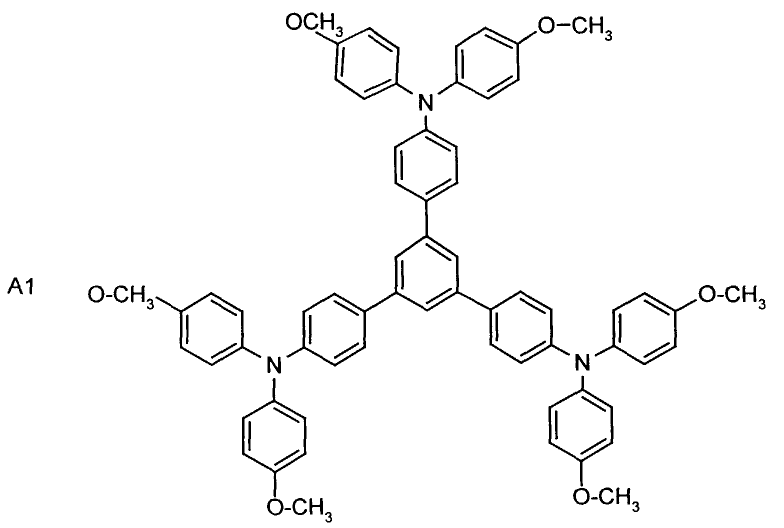

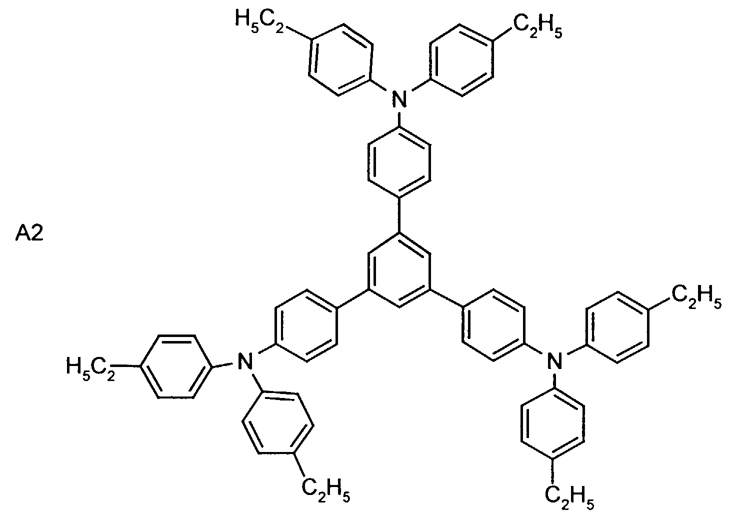

Neben der tertiären Aminoverbindung können gegebenenfalls weitere Lochleiter, z.B. in Form einer Mischung mit der tertiären Aminoverbindung, zum Aufbau des elektrolumineszierenden Elementes eingesetzt werden. Dabei kann es sich einerseits um eine oder mehrere Verbindungen der Formel (II), wobei auch Gemische von Isomeren umfaßt werden, andererseits auch um Mischungen von lochtransportierenden Verbindungen mit Verbindungen von tertiären Aminoverbindungen - mit der allgemeinen Formel (II) - mit verschiedener Struktur handeln.

Eine Zusammenstellung möglicher lochinjizierender und lochleitender Materialien ist in EP-A 0 532 798 angegeben.

Im Falle von Mischungen der aromatischen Amine können die Verbindungen in einem beliebigen Verhältnis eingesetzt werden.

Beispielhaft seien genannt:

Materialien, die lochleitende Eigenschaften aufweisen und in reiner Form oder als Mischpartner zu den tertiären Aminoverbindungen eingesetzt werden können, sind beispielsweise die folgenden Verbindungen, wobei X¹ bis X⁶ unabhängig voneinander für H, Halogen, Alkyl, Aryl, Alkoxy, Aryloxy stehen.

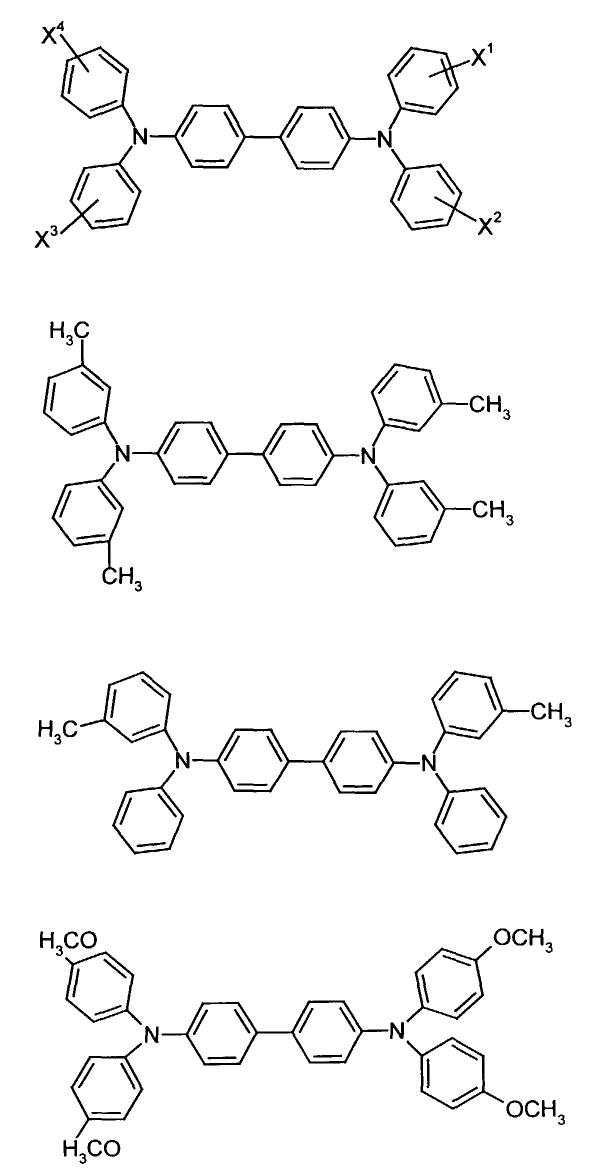

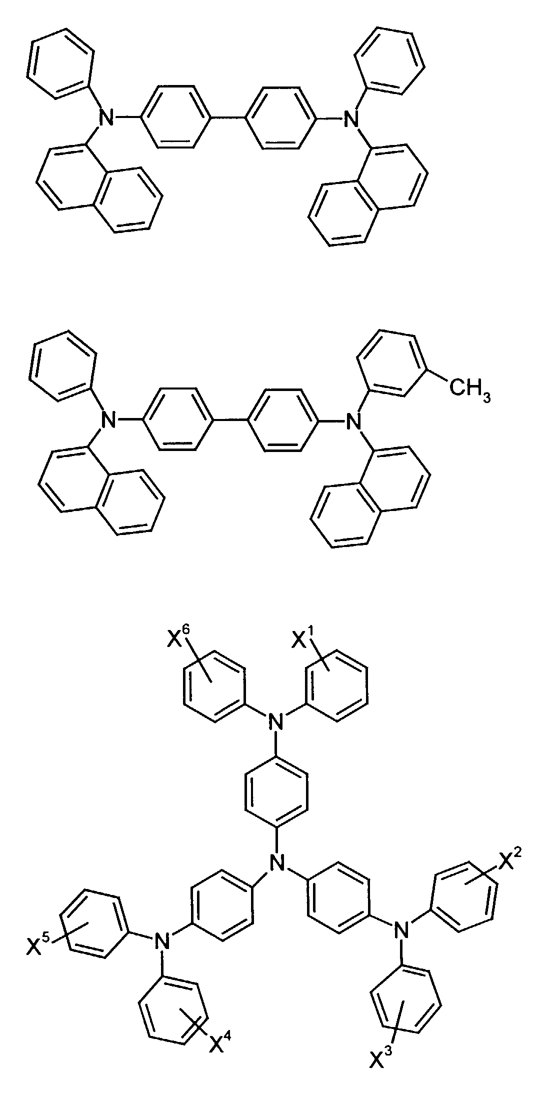

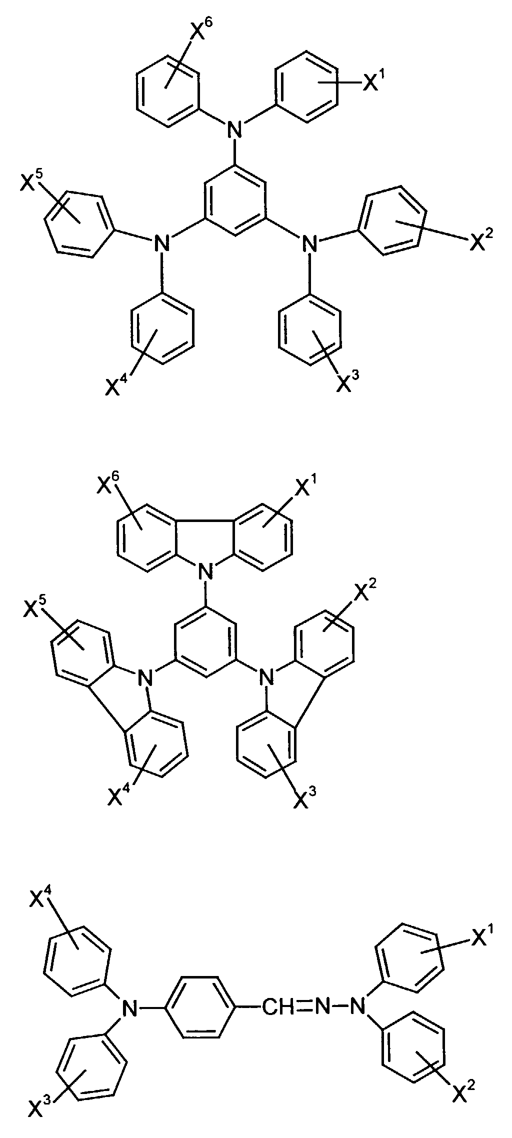

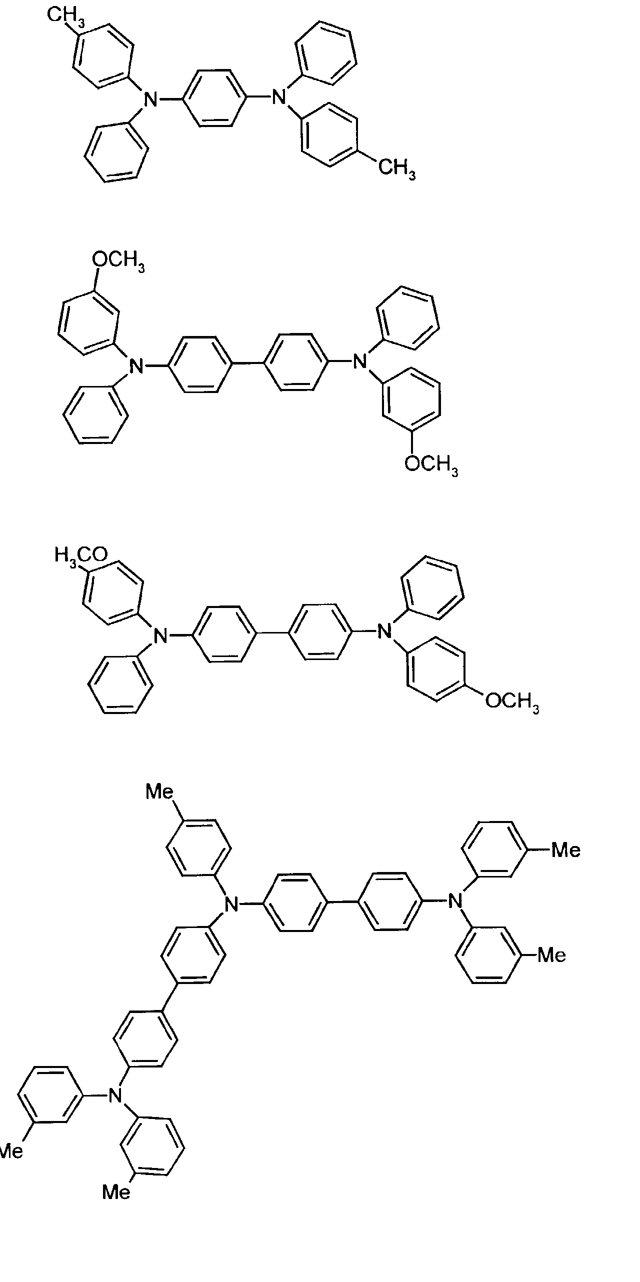

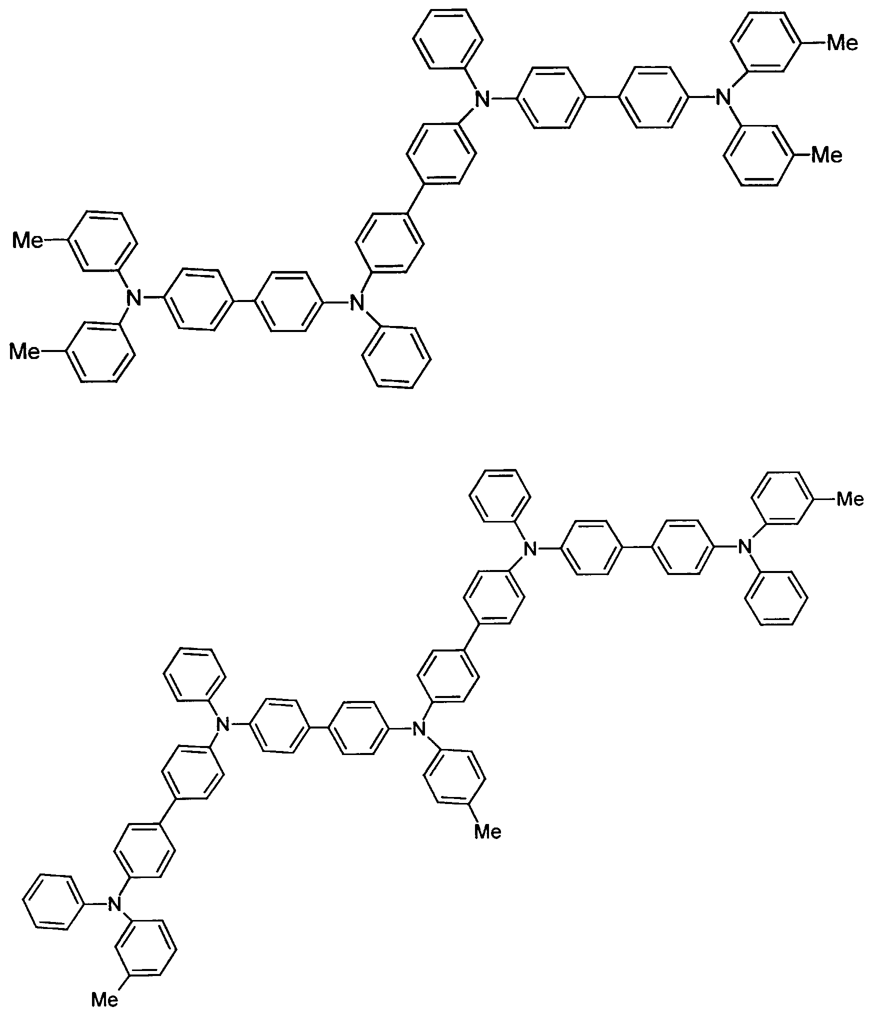

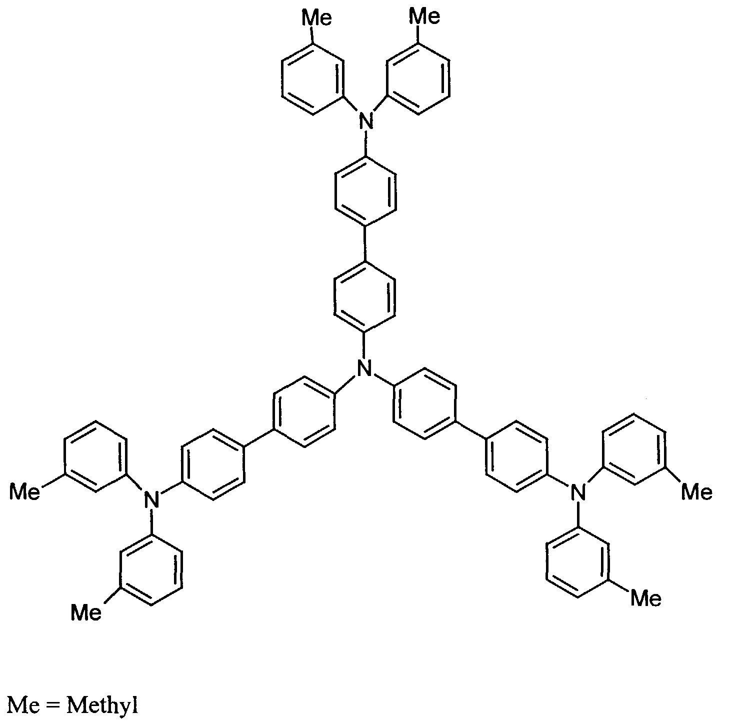

Diese und weitere Beispiele sind beschrieben in J. Phys. Chem. 1993, 97, 6240-6248 und Appl. Phys. Lett., Vol. 66, No. 20, 2679-2681.

Generell können verschiedene Amine mit unterschiedlicher Grundstruktur und/oder unterschiedlichen Substitutionsmustern gemischt werden.

X¹ bis X⁶ stehen unabhängig voneinander vorzugsweise für Wasserstoff, Fluor, Chlor, Brom, (C₁-C₁₀)-, insbesondere (C₁-C₄)- Alkyl oder -Alkoxy, Phenyl, Naphthyl, Phenoxy und/oder Naphthyloxy. Die aromatischen Ringe können ein-, zwei, drei- oder vierfach, gleich oder verschieden durch mindestens einen Rest X¹ bis X⁶ substituiert sein.

Die Polythiophene der wiederkehrenden Struktureinheit der Formel (I) sind bekannt (vgl. EP-A 0 440 958 und 0 339 340). Die Herstellung der erfindungsgemäßen Dispersionen bzw. Lösungen ist in EP-A 0 440 957 und DE-A 42 11 459 beschrieben.

Die Polythiophene werden in der Dispersion bzw. Lösung bevorzugt in kationischer Form, wie sie z.B. durch Behandlung der neutralen Thiophene mit Oxidationsmitteln erhalten werden, eingesetzt. Übliche Oxidationsmittel wie Kaliumperoxodisulfat werden für die Oxidation verwendet. Durch die Oxidation erhalten die Polythiophene positive Ladungen, die in den Formeln nicht dargestellt sind, da ihre Zahl und ihre Position nicht einwandfrei feststellbar sind. Gemäß den Angaben in EP-A 0 339 340 können sie direkt auf Trägern hergestellt werden.

Vorzugsweise stehen Q¹ und Q² in Formel (I) für -(CH₂)ₘ-CH₂- mit m = 1 bis 4, ganz besonders bevorzugt für Ethylen.

Bevorzugte kationische oder neutrale Polydioxythiophene sind aus Struktureinheiten der Formel (Ia) oder (Ib) aufgebaut 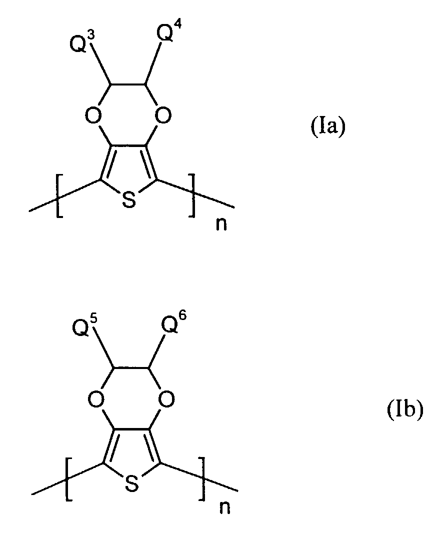 worin
- Q³ und Q⁴: unabhängig voneinander für Wasserstoff, gegebenenfalls substituiertes (C₁-C₁₈)-Alkyl, vorzugsweise (C₁-C₁₀)-, insbesondere (C₁-C₆)-Alkyl, (C₂-C₁₂)-Alkenyl, vorzugsweise (C₂-C₈)-Alkenyl, (C₃-C₇)-Cycloalkyl, vorzugsweise Cyclopentyl, Cyclohexyl, (C₇-C₁₅)-Aralkyl, vorzugsweise Phenyl-(C₁-C₄)-alkyl, (C₆-C₁₀)-Aryl, vorzugsweise Phenyl, Naphthyl, (C₁-C₁₈)-Alkoxy, vorzugsweise (C₁-C₁₀)-Alkoxy, beispielsweise Methoxy, Ethoxy, n-oder iso-Propoxy oder (C₂-C₁₈)-Alkyloxyester steht und
- Q⁵ und Q⁶: unabhängig voneinander für Wasserstoff, mit jeweils mindestens einer Sulfonatgruppe substituiertes (C₁-C₁₈)-Alkyl, vorzugsweise (C₁-C₁₀)-, insbesondere (C₁-C₆)-Alkyl, (C₂-C₁₂)-Alkenyl, vorzugsweise (C₂-C₈)-Alkenyl, (C₃-C₇)-Cycloalkyl, vorzugsweise Cyclopentyl, Cyclohexyl, (C₇-C₁₅)-Aralkyl, vorzugsweise Phenyl-(C₁-C₄)-alkyl, (C₆-C₁₀)-Aryl, vorzugsweise Phenyl, Naphthyl, (C₁-C₁₈)-Alkoxy, vorzugsweise (C₁-C₁₀)-Alkoxy, beispielsweise Methoxy, Ethoxy, n-oder iso-Propoxy oder (C₂-C₁₈)-Alkyloxyester steht, wobei falls Q⁵ für Wasserstoff steht, Q⁶ verschieden von Wasserstoff ist und umgekehrt und
- n: für eine ganze Zahl von 2 bis 10 000, vorzugsweise 5 bis 5 000 steht.

Besonders bevorzugt sind kationische bzw. neutrale Polythiophene der Formeln (Ia-1) und (Ib-1) 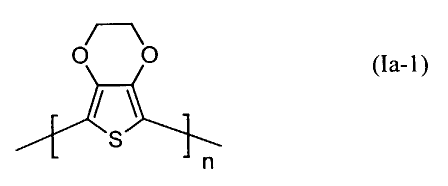 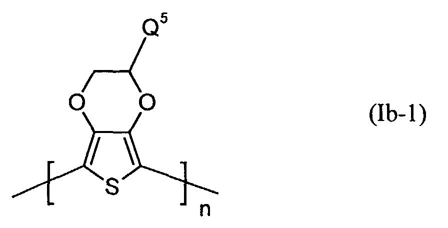 worin
- Q⁵ und n: die oben angegebene Bedeutung haben.

Zur Kompensation der positiven Ladung enthält die kationische Form der Polythiophene Anionen, vorzugsweise Polyanionen.

Als Polyanionen dienen vorzugsweise die Anionen von polymeren Carbonsäuren, wie Polyacrylsäuren, Polymethacrylsäure oder Polymaleinsäuren und polymeren Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol, sein.

Besonders bevorzugt ist das Anion der Polystyrolsulfonsäure als Gegenion.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben-Weyl, Methoden der organischen Chemie, Bd. E 20 Makromolekulare Stoffe, Teil 2 (1987), S. 1141 f).

Anstelle der für die Bildung der Dispersionen aus Polydioxythiophenen und Polyanionen erforderlichen freien Polysäuren, kann man auch Gemische aus Alkalisalzen der Polysäuren und entsprechenden Mengen an Monosäuren einsetzen.

Im Falle der Formel (Ib) und (Ib-1) tragen die Polydioxythiophene positive und negative Ladung in der Monomereinheit selbst.

Die erfindungsgemäßen Anordnungen enthalten gegebenenfalls als Bindemittel Polymere und/oder Copolymere wie z.B. Polycarbonate, Polyestercarbonate, Copolymere des Styrols wie SAN oder Styrolacrylate, Polysulfone, Polymerisate auf Basis von Vinylgruppen-haltigen Monomeren wie z.B. Poly(meth)acrylate, Polyvinylpyrrolidon, Polyvinylcarbazol, Vinylacetat- und Vinylalkoholpolymere und ―copolymere, Polyolefine, cyclische Olefincopolymere, Phenoxyharze usw. Es können auch Mischungen verschiedener Polymere eingesetzt werden. Die polymeren Binder weisen Molekulargewichte von 10 000 bis 2 000 00 g/mol auf, sind löslich und filmbildend und sind im sichtbaren Spektralbereich transparent. Sie sind z.B. beschrieben in Encyclopedia of Polymer Science and Engineering, 2^{nd} Ed. bei A. Wiley-Intersciencepublication. Sie werden üblicherweise in einer Menge bis zu 95, vorzugsweise bis zu 80 Gew.-%, bezogen auf das Gesamtgewicht der elektrolumineszierenden Elemente, eingesetzt.

Der Azomethin-Metallkomplex ist vorzugsweise eine Verbindung der allgemeinen Formel (III) a bis (III)c 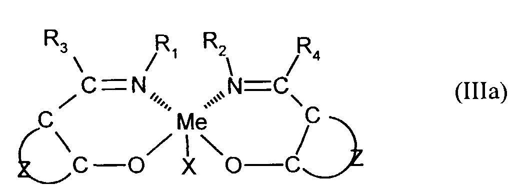 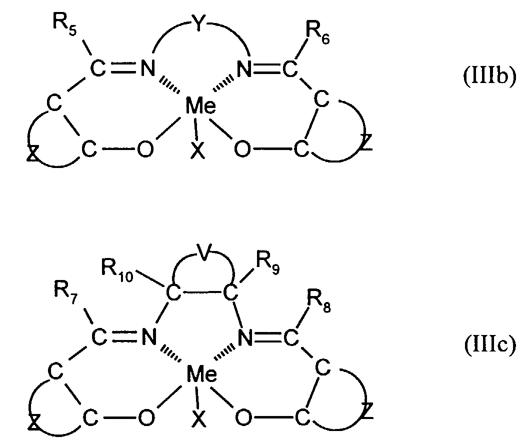 worin
- Me: für ein Metall steht und
- R₁, R₂, R₃, R₄, R₅, R₆, R₇, R₈, R₉ und R₁₀: unabhängig voneinander für Wasserstoff oder einen gegebenenfalls substituierten Alkyl- oder Arylrest stehen,
- X: für ein Halogenatom und
- V, Y, Z: für Atome stehen, die einen Kern vervollständigen, der wenigstens jeweils aus einem Ring besteht.

Generell können dreiwertige Metalle benutzt werden, von denen bekannt ist, daß sie Chelate bilden (z.B. Al, Ga, In).
- Z: vervollständigt ein aromatisches Molekülteil, das wenigstens aus einem Ring besteht, wobei weitere zusätzliche aliphatische oder aromatische Ringe angebunden sein können.

Der Azomethin-Metallkomplex ist besonders bevorzugt eine Verbindung der allgemeinen Formel (IIId), (IIIe) und (IIIf): 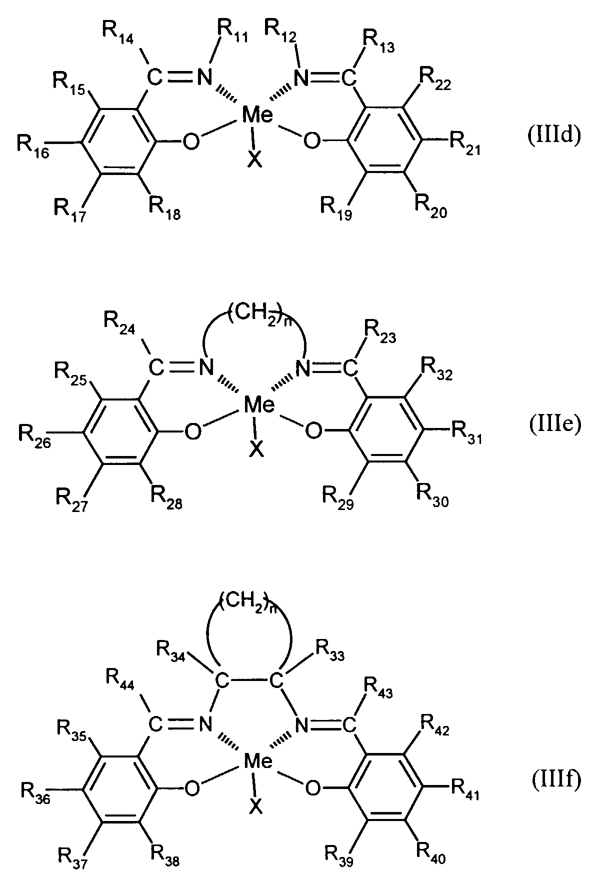 in welcher
- X: für F, Cl oder Br steht,
- R₁₁-R₄₄: unabhängig voneinander für Wasserstoff, gegebenenfalls substituiertes C₁-C₁₆-Alkyl oder Aryl stehen,
- n: für eine Zahl von 1 bis 10 steht.

Beispielhaft für die Verbindungen (III) seien genannt:

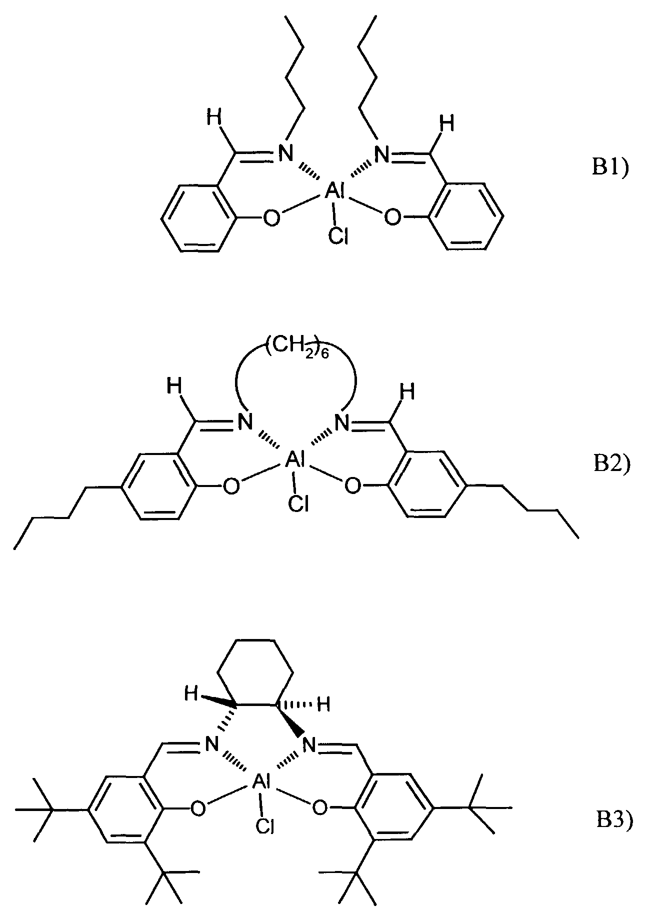

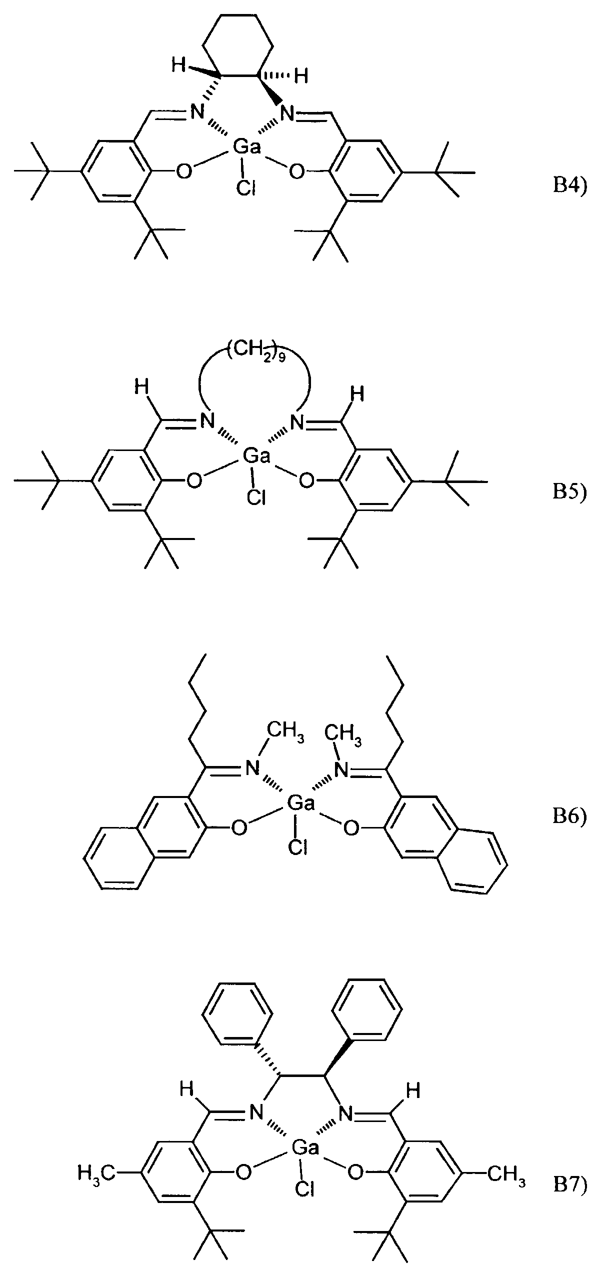

Es können eine oder mehrere Verbindungen der Formeln B1 bis B7 eingesetzt werden.

Azomethin-Metallkomplexe die Fluoreszenz zeigen, sind bekannt aus der analytischen Chemie (K. Morishige, Analytica Chimica Acta 72, 295 (1974)). Bisher sind Azomethin-Metallkomplexe als Emitter und/oder Elektronenleiter in organischen Leuchtdioden nur als Zink-Komplexe verwendet worden (Y. Hamada, T. Sano, M. Fujita, T. Fujii, Y. Nishio, K. Shibata, Jpn. J. Appl. Phys. 32, L511 (1993)).

Die Synthese der Komplexe kann nach einer modifizierten Variante geschehen, wie z.B. beschrieben in L. Sacconi, P. Paoletti, M. Ciampolini, J. Am. Chem. Soc., 85, 411 (1963).

Zur Herstellung des elektrolumineszierenden Elements wird der Azomethin-Metallkomplex sowie gegebenenfalls die tertiäre Aminoverbindung und der Binder in einem geeigneten Lösemittel gelöst und durch Gießen, Rakeln oder Spincoating auf eine geeignete Unterlage aufgebracht. Der Metallkomplex kann gegebenenfalls aber auch separat als Schicht durch einen Aufdampfprozess aufgebracht werden. Bei der Unterlage kann es sich z.B. um Glas oder ein Kunststoffmaterial handeln, das mit einer transparenten Elektrode versehen ist. Als Kunststoffmaterial kann z.B. eine Folie aus Polycarbonat, Polyester wie Polyethylenterephthalat oder Polyethylennaphthalat, Polysulfon oder Polyimid eingesetzt werden.

Als transparente Elektroden sind geeignet
a) Metalloxide, z.B. Indium-Zinn-Oxid (ITO), Zinnoxid (NESA), Zinkoxid, dotiertes Zinnoxid, dotiertes Zinkoxid, etc.,
b) semi-transparente Metallfilme, z.B. Au, Pt, Ag, Cu etc.,
c) leitfähige Polymerfilme wie Polyaniline, Polythiophene, etc.

Die Metalloxid- und die semitransparenten Metallfilmelektroden werden durch Techniken wie Aufdampfen, Aufsputtern, Platinierung, etc., in dünner Schicht aufgebracht. Die leitfähigen Polymerfilme werden durch Techniken wie Spincoaten, Casting, Rakeln etc. aus der Lösung aufgebracht.

Die Dicke der transparenten Elektrode beträgt 3 nm bis etwa mehrere µm, vorzugsweise 10 nm bis 500 nm.

Die elektrolumineszierende Schicht wird direkt auf die transparente Elektrode oder auf eine gegebenenfalls vorhandene ladungstransportierende Schicht als dünner Film aufgebracht. Die Dicke des Films beträgt 10 bis 500 nm, vorzugsweise 20 bis 400 nm, besonders bevorzugt 50 bis 250 nm.

Auf die elektrolumineszierende Schicht kann eine weitere ladungstransportierende Schicht eingefügt werden, bevor eine Gegenelektrode aufgebracht wird.

Eine Zusammenstellung von geeigneten ladungstransportierenden Zwischenschichten, bei denen es sich um loch- und/oder elektronenleitenden Materialien handeln kann, die in polymerer oder niedermolekularer Form gegebenenfalls als Blend vorliegen können, ist in EP-A 0 532 798 aufgeführt. Besonders geeignet sind speziell substituierte Polythiophene, die über lochtransporierende Eigenschaften verfügen. Sie sind beispielsweise in EP-A 0 686 662 beschrieben.

Der Gehalt an niedermolekularem Lochleiter in einem polymeren Binder ist im Bereich von 2 bis 97 Gew.-% variierbar; bevorzugt beträgt der Gehalt 5 bis 95 Gew.-%, besonders bevorzugt 10 bis 90 Gew.-%, insbesondere 10 bis 85 Gew.-%. Die lochinjizierenden bzw. lochleitenden Zonen können mit verschiedenen Methoden deponiert werden.

Filmbildende Lochleiter können auch in reiner Form (100 %ig) eingesetzt werden. Gegebenenfalls kann auch die lochinjizierende bzw. lochleitende Zone Anteile einer elektrolumineszierenden Substanz enthalten.

Blends, die ausschließlich aus niedermolekularen Verbindungen bestehen, können aufgedampft werden; lösliche und filmbildende Blends, die neben niedermolekularen Verbindungen auch einen Binder enthalten können, können aus einer Lösung z.B. mittels Spin-Coating, Gießen, Rakeln deponiert werden.

Es ist auch möglich, emittierende und/oder elektronenleitende Substanzen in einer separaten Schicht auf die lochleitende Schicht aufzubringen. Dabei kann eine emittierende Substanz auch der die Verbindung (III) enthaltenden Schicht zudotiert ("Dopant") und zusätzlich eine elektronenleitende Substanz aufgebracht werden. Eine elektrolumineszierende Substanz kann auch der elektroneninjizierenden bzw. elektronenleitenden Schicht zugesetzt werden.

Der Gehalt an niedermolekularen Elektronenleitern im polymeren Binder ist im Bereich von 2 bis 95 Gew.-% variierbar; bevorzugt beträgt der Gehalt 5 bis 90 Gew.-%, besonders bevorzugt 10 bis 85 Gew.-%. Filmbildende Elektronenleiter können auch in reiner Form (100 %ig) eingesetzt werden.

Die Gegenelektrode besteht aus einer leitfähigen Substanz, die transparent sein kann. Vorzugsweise eignen sich Metalle, z.B. Al, Au, Ag, Mg, In, etc. oder Legierungen und Oxide dieser, die durch Techniken wie Aufdampfen, Aufsputtern, Platinierung aufgebracht werden können.

Die erfindungsgemäße Anordnung wird durch zwei elektrische Zuführungen (z.B. Metalldrähte) mit den beiden Elektroden in Kontakt gebracht.

Die Anordnungen emittieren beim Anlegen einer Gleichspannung im Bereich von 0,1 bis 100 Volt Licht der Wellenlänge von 200 bis 2000 nm. Sie zeigen im Bereich von 200 bis 2000 nm Photolumineszenz.

Die erfindungsgemäßen Anordnungen sind zur Herstellung von Einheiten zur Beleuchtung und zur Informationsdarstellung geeignet.

### Beispiele

### Beispiel 1

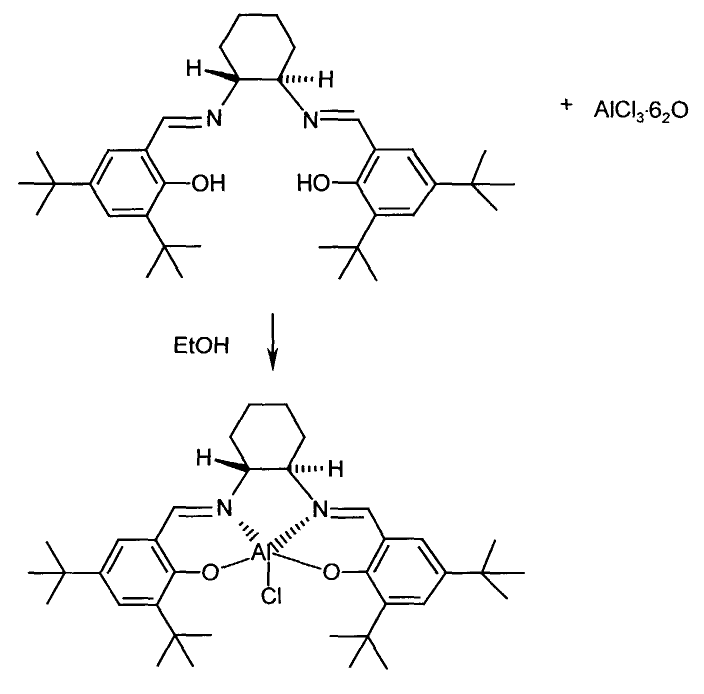

1,0 g (1,829 mmol) (R,R)-(-)-N,N'-Bis-(3,5-di-tert.-butylsalicyliden)-1,2-cyclohexandiamin (käuflich; Fa. Aldrich) werden zusammen mit 0,205 g (3,657 mmol) Kaliumhydroxid in 100 ml Ethanol vorgelegt. Zu dieser Lösung tropft man eine Lösung von 0,441 g (1,829 mmol) Aluminium(III)-chlorid-hydrat in 10 ml Methanol hinzu und kocht unter Schutzgas 6 Stunden am Rückfluß. Der Reaktionsansatz wird eingeengt und der erhaltene Feststoff in Methanol gelöst und durch Zugabe von Wasser ausgefüllt. Nach dem Trocknen erhält man einen zitronengelben Feststoff (0,75 g ≙ 67,5 % der Theorie).

### Beispiel 2

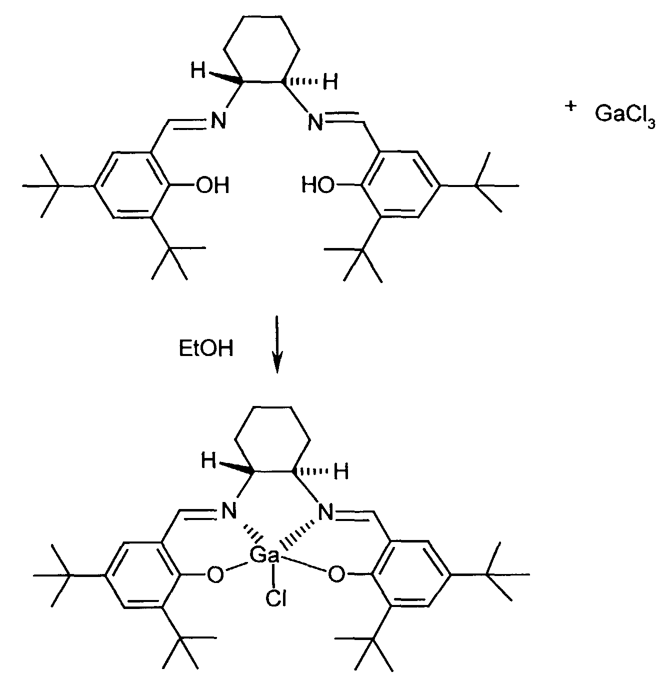

1,0 g (1,829 mmol) (R,R)-(-)-N,N'-Bis-(3,5-di-tert.-butylsalicyliden)-1,2-cyclohexandiamin (käuflich; Fa. Aldrich) werden zusammen mit 0,205 g (3,657 mmol) Kaliumhydroxid in 100 ml Ethanol vorgelegt. Zu dieser Lösung tropft man 3,54 g einer 9 %igen Lösung von Gallium-(III)-chlorid in Methanol hinzu und kocht unter Schutzgas 6 Stunden am Rückfluß. Der Reaktionsansatz wird eingeengt und der erhaltene Feststoff in Methanol gelöst und durch Zugabe von Wasser ausgefällt. Nach dem Trocknen erhält man einen gelben Feststoff (0,44 g ≙ 37 % der Theorie).

### Beispiele, Physikalischer Teil:

### Beispiel 1

Die erfindungsgemäße Substanz B4 wird zum Aufbau einer organischen Leuchtdiode (OLED) genutzt. Bei der Herstellung der OLED wird folgendermaßen vorgegangen:
1. Reinigung des ITO-Substrats
   ITO-beschichtetes Glas (Merck Balzers AG, FL, Part. No. 253 674 XO) wird in 50 mm x 50 mm-große Stücke (Substrate) geschnitten. Die Substrate werden anschließend in 3 %iger wäßriger Mukasollösung im Ultraschalbad 15 min lang gereinigt. Danach werden die Substrate mit destilliertem Wasser gespült und in einer Zentrifuge trocken geschleudert. Dieser Spül- und Trockenvorgang wird 10 mal wiederholt.
2. Aufbringen der ®Baytron P-Schicht auf das ITO
   Etwa 10 ml der 1,3 %igen Polyethylendioxythiophen/Polystyrolsulphonsäure-Lösung (Bayer AG, Baytron P) werden filtriert (Millipore HV, 0,45 µm). Das Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 500 U/min über den Zeitraum von 3 min abgeschleudert. Danach wird das so beschichtete Substrat 5 min lang bei 110°C auf einer Heizplatte getrocknet. Die Schichtdicke beträgt 60 nm (Tencor, Alphastep 200).
3. Aufbringen der lochleitenden Schicht
   5 ml einer 1,5 %igen Dichlorethanlösung aus 1 Gew.-Teil Polyvinylcarbazol (BASF, Luvican), 1 Gew.-Teil Phenylamin (Agfa-Gevaert, Verbindung A1) und 1 Gew.-Teil Phenylamin (Agfa-Gevaert, A2) werden filtriert (Millipore HV, 0,45 µm) und auf der getrockneten Baytron P Schicht verteilt. Anschließend wird die überstehende Lösung durch Rotation des Tellers bei 800 U/min 30 sec lang abgeschleudert. Danach wird das so beschichtete Substrat 5 min lang bei 110°C auf einer Heizplatte getrocknet. Die Gesamtschichtdicke beträgt 150 nm.
4. Aufdampfen der lichtemittierenden/elektroneninjizierenden Schicht
   Auf die so hergestellten zwei organischen Schichten wird eine dritte organische Schicht, nämlich die erfindungsgemäße Substanz B3, thermisch gedampft. Dies wird in einer Aufdampfanlage (Leybold, Univex 350) durchgeführt. Der Druck in der Aufdampfanlage beträgt während des Aufdampfens 10⁻³ Pa und die Aufdampfrate beträgt 2 Å/sec. Die Gesamtschichtdicke der 3 organischen Schichten beträgt 200 nm.
5. Aufdampfen der Metallkathode
   Aufdas organische Schichtsystem wird eine Metallelektrode gedampft. Dazu wird das Substrat mit dem organischen Schichtsystem nach unten auf eine Lochmaske (Lochdurchmesser 5 mm) gelegt. Aus zwei Aufdampfschiffchen werden bei einem Druck von 10⁻³ Pa parallel die Elemente Mg und Ag verdampft. Die Aufdampfraten betragen für Mg: 28 Å/sec. Die Dicke der aufgedampften Metallkontakte beträgt 500 nm.

Die beiden Elektroden der organischen LED werden über elektrische Zuführungen mit einer Spannungsquelle verbunden. Der positive Pol ist mit deer ITO-Elektrode, der negative Pol ist mit der MgAg-Elektrode verbunden.

Bereits ab einer Spannung von 4 Volt läßt sich mit einer Photodiode (EG&G C30809E) Elektrolumineszenz nachweisen. Bei einer Spannung von 10 Volt fließt ein Flächenstrom von 1 mA/cm² und die Elektrolumineszenz ist gut sichtbar. Die Farbe der Elektrolumineszenz ist grün-blau.

## Patentansprüche

1. Elektrolumineszierende Anordnung, aufgebaut aus einem Substrat, einer Anode, einem elektrolumineszierenden Element und einer Kathode, wobei wenigstens eine der beiden Elektroden im sichtbaren Spektralbereich transparent ist und das elektrolumineszierende Element eine oder mehrere Zonen aus der Gruppe der lochinjizierenden Zone, lochtransportierende Zone, elektrolumineszierenden Zone, elektronentransportierenden Zone und elektroneninjizierenden Zone in der genannten Reihenfolge enthält, wobei jede der vorhandenen Zonen auch Aufgaben der anderen genannten Zonen übernehmen kann, dadurch gekennzeichnet, daß das elektrolumineszierende Element einen Azomethin-Metallkomplex enthält.

2. Elektrolumineszierende Anordnung gemäß Anspruch 1, dadurch gekennzeichnet, daß die lochinjizierende Zone ein neutrales oder kationisches Polythiophen der Formel (I) enthält, 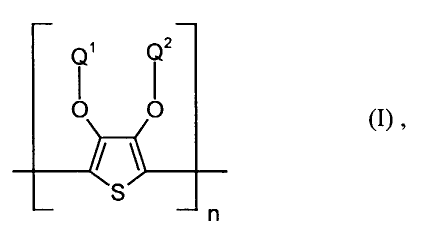 wobei
Q¹ und Q² unabhängig voneinander für Wasserstoff, gegebenenfalls substituiertes (C₁-C₂₀)-Alkyl, CH₂OH oder (C₆-C₁₄)-Aryl stehen oder
Q¹ und Q² zusammen -(CH₂)ₘ-CH₂- mit m = 0 bis 12, vorzugsweise 1 bis 5, (C₆-C₁₄)-Arylen bedeuten, und
n für eine ganze Zahl von 2 bis 10 000, vorzugsweise 5 bis 5 000 steht.

3. Elektrolumineszierende Anordnungen gemäß Anspruch 1, dadurch gekennzeichnet, daß die lochinjizierende Zone ein neutrales oder kationisches Polythiophen der Formel (Ia) oder (Ib) oder ein Gemisch enthält, 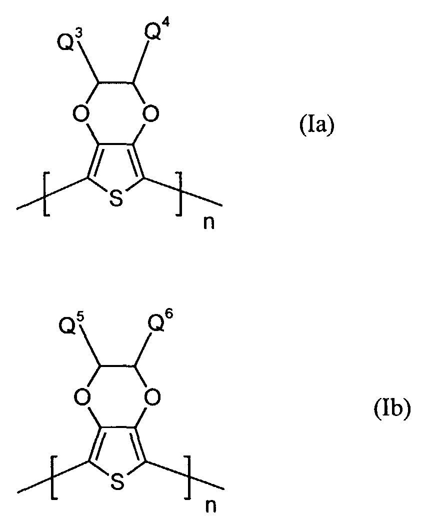 worin
Q³ und Q⁴ unabhängig voneinander für Wasserstoff, gegebenenfalls substituiertes (C₁-C₁₈)-Alkyl, (C₂-C₁₂)-Alkenyl, (C₃-C₇)-Cycloalkyl, (C₇-C₁₅)-Aralkyl, (C₆-C₁₀)-Aryl, (C₁-C₁₈)-Alkoxy oder (C₂-C₁₈)-Alkyloxyester steht und
Q⁵ und Q⁶ unabhängig voneinander für Wasserstoff, mit jeweils mindestens einer Sulfonatgruppe substituiertes (C₁-C₁₈)-Alkyl, (C₂-C₁₂)-Alkenyl, (C₃-C₇)-Cycloalkyl, (C₇-C₁₅)-Aralkyl, (C₆-C₁₀)-Aryl, (C₁-C₁₈)-Alkoxy oder (C₂-C₁₈)-Alkyloxyester steht, wobei falls Q⁵ für Wasserstoff steht, Q⁶ verschieden von Wasserstoff ist und umgekehrt,
n für eine ganze Zahl von 2 bis 10 000 steht.

4. Elektrolumineszierende Anordnungen gemäß Anspruch 3, dadurch gekennzeichnet, daß die kationischen bzw. neutralen Polythiophene der Formeln (Ia-1) und (Ib-1) entsprechen, 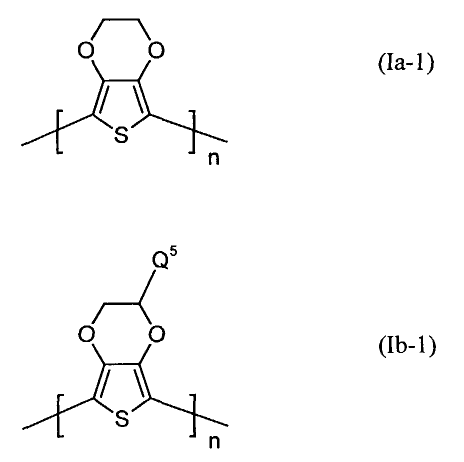 worin
Q⁵ und n in Anspruch 3 angegebene Bedeutung haben.

5. Elektrolumineszierende Anordnungen gemäß Anspruch 2 bis 4, dadurch gekennzeichnet, daß als Polyanionen die Anionen von polymeren Carbonsäuren und/oder polymeren Sulfonsäuren enthalten sind.

6. Elektrolumineszierende Anordnungen gemäß Anspruch 5, dadurch gekennzeichnet, daß als Gegenion Polystyrolsulfonsäure und/oder ein Erdalkalisalz davon enthalten ist.

7. Elektrolumineszierende Anordnung gemäß Anspruch 1, dadurch gekennzeichnet, daß die lochinjizierende und/oder lochtransportierende Zone eine aromatische tertiäre Aminoverbindung der allgemeinen Formel (II) enthält 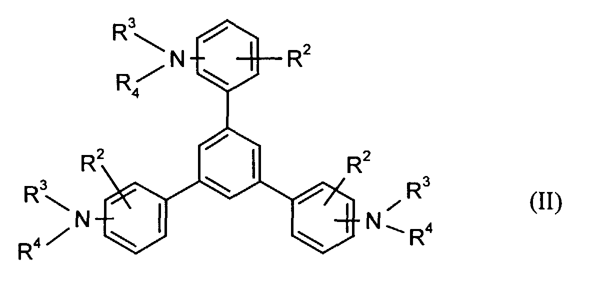 in welcher
R² für Wasserstoff, gegebenenfalls substituiertes Alkyl oder Halogen steht,
R³ und R⁴ unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Aralkyl oder Cycloalkyl stehen.

8. Elektrolumineszierende Anordnung gemäß Anspruch 7, dadurch gekennzeichnet, daß in Formel (II)
R² für Wasserstoff oder (C₁-C₆)-Alkyl steht,
R³ und R⁴ unabhängig voneinander für (C₁-C₆)-Alkyl, (C₁-C₄)-Alkoxycarbonyl-(C₁-C₆)-alkyl, jeweils gegebenenfalls durch (C₁-C₄)-Alkyl und/oder (C₁-C₄)-Alkoxy substituiertes Phenyl, Naphthyl, Phenyl-(C₁-C₄)-alkyl, Naphthyl-C₁-C₄-alkyl, Cyclopentyl oder Cyclohexyl stehen.

9. Elektrolumineszierende Anordnung gemäß Anspruch 7, dadurch gekennzeichnet, daß die tertiäre Aminoverbindung ausgewählt ist aus den folgenden Verbindungen:

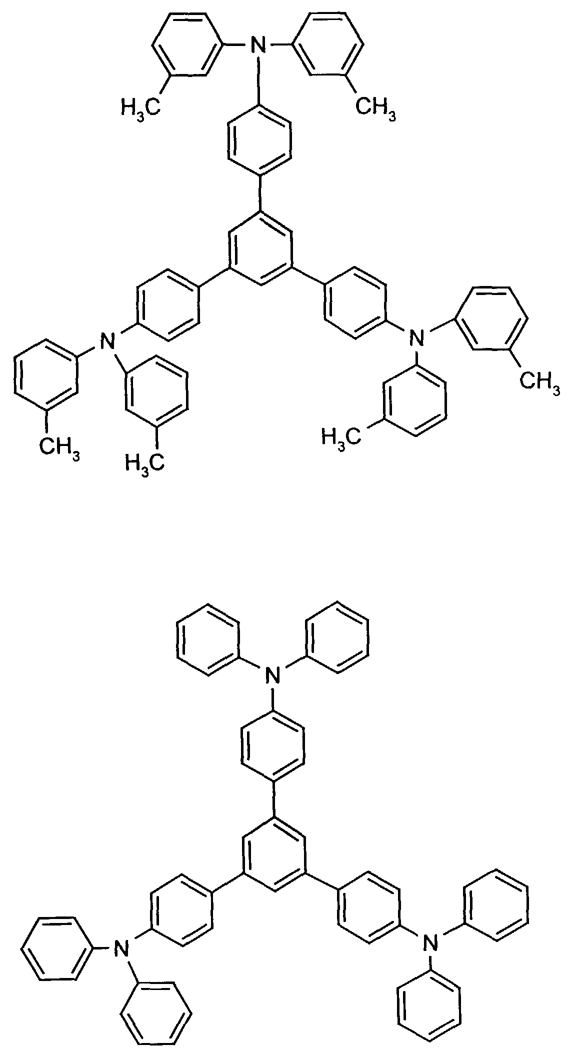

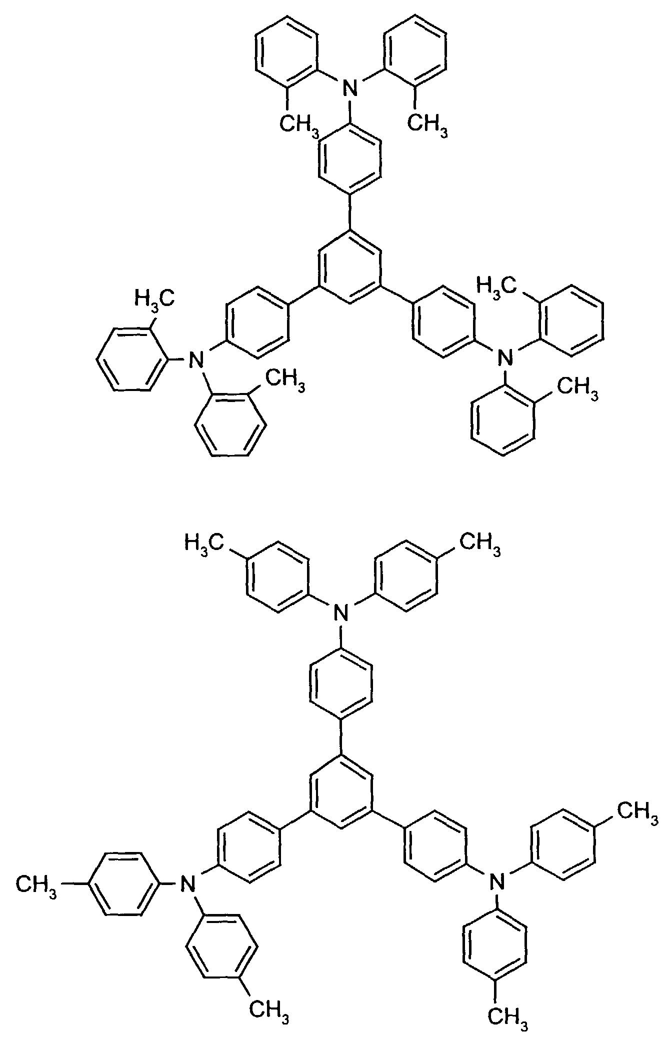

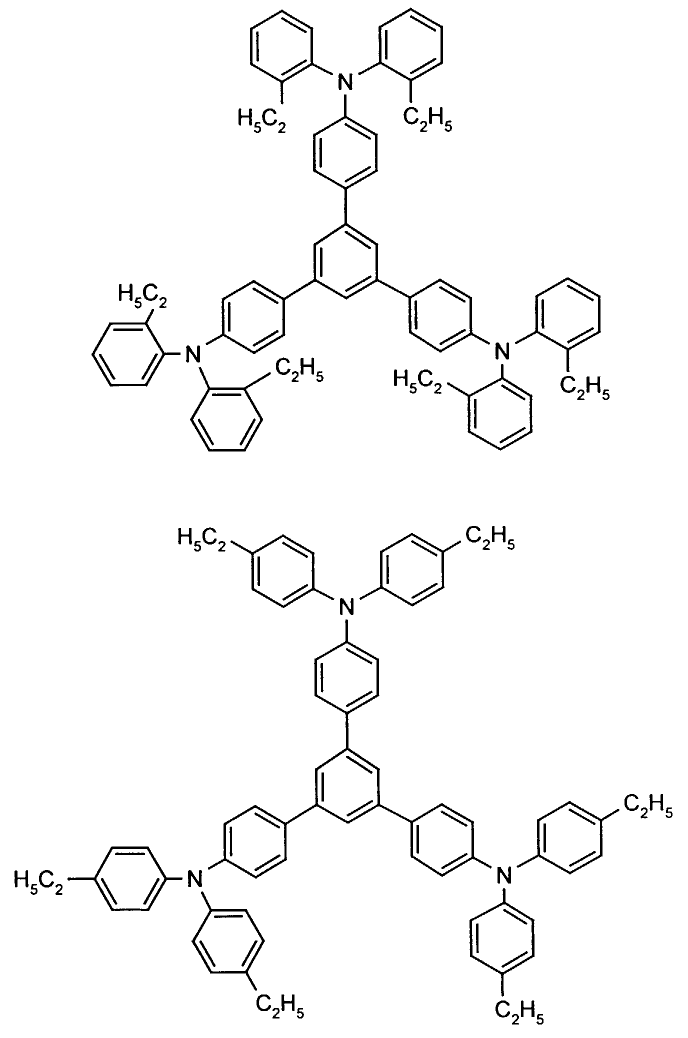

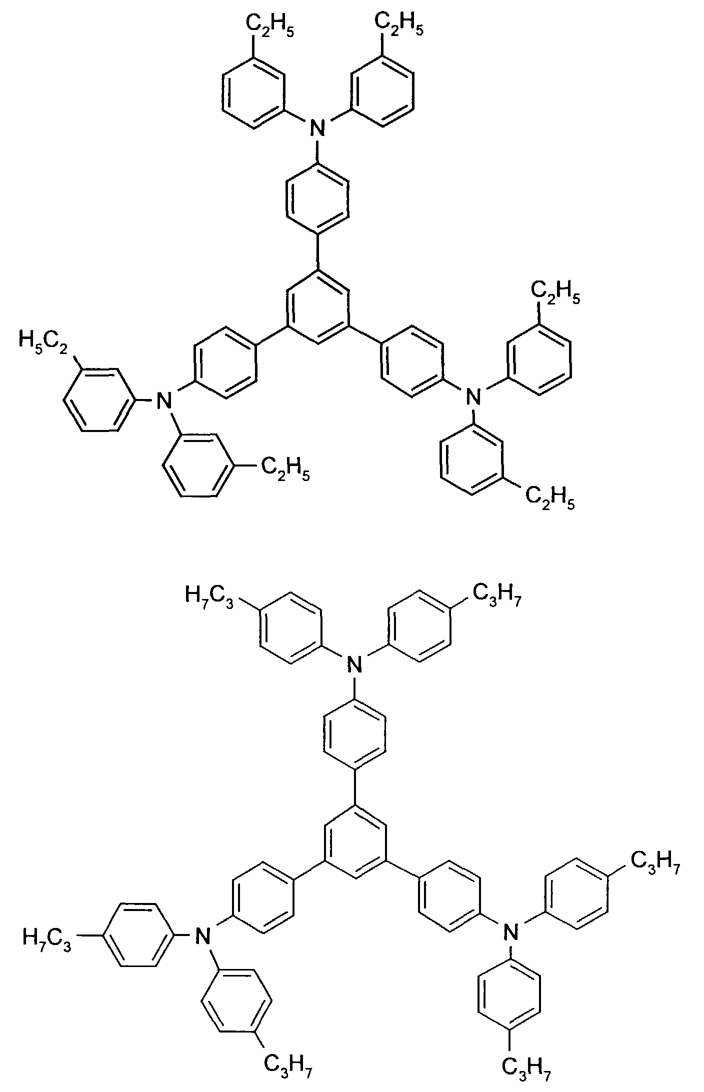

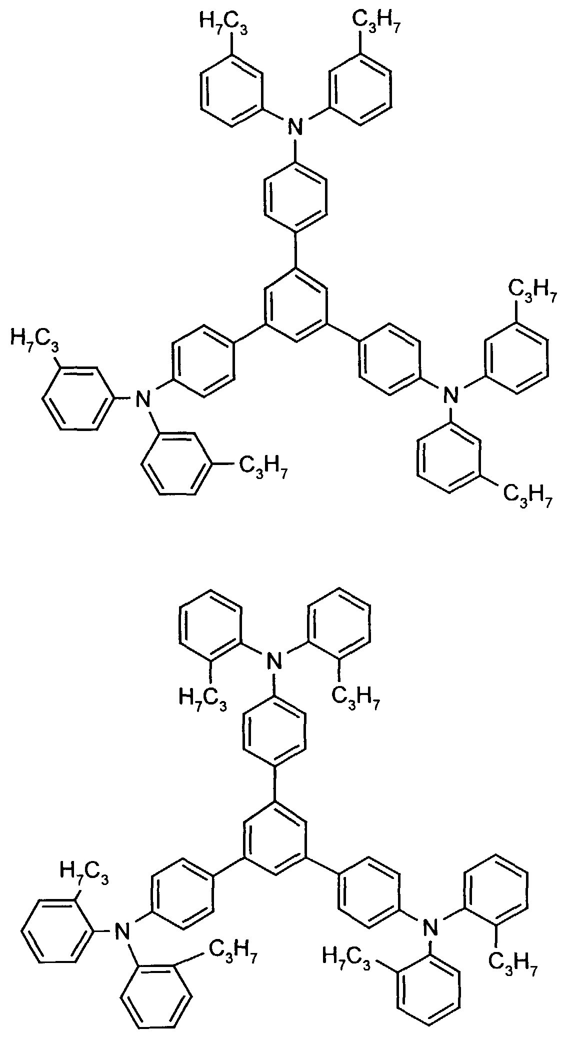

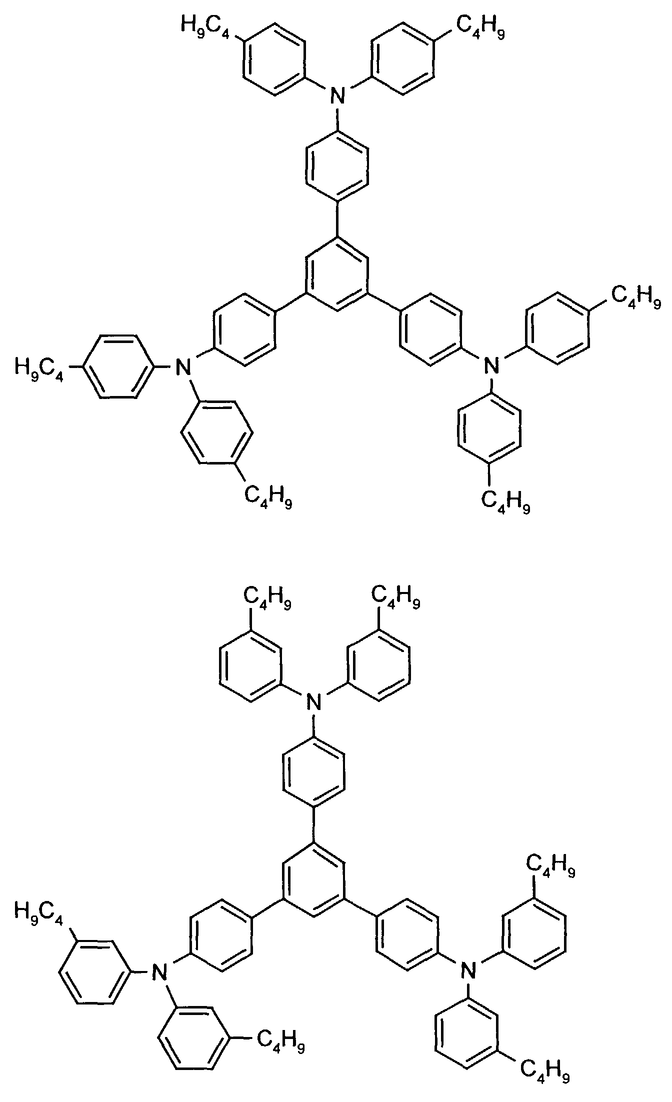

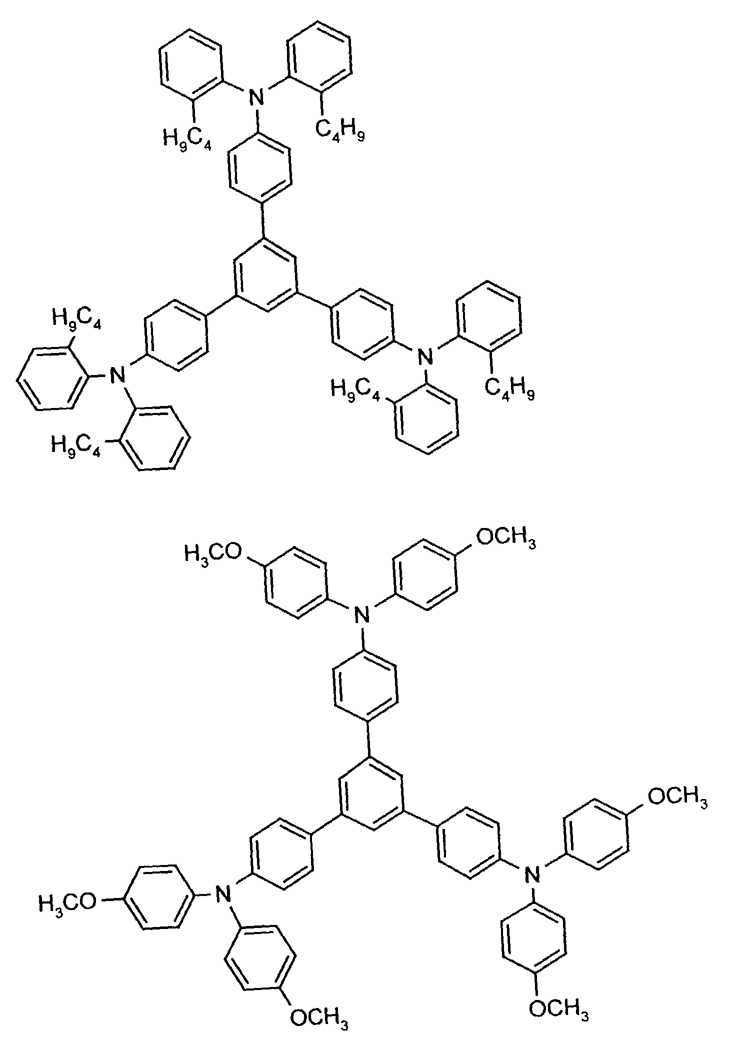

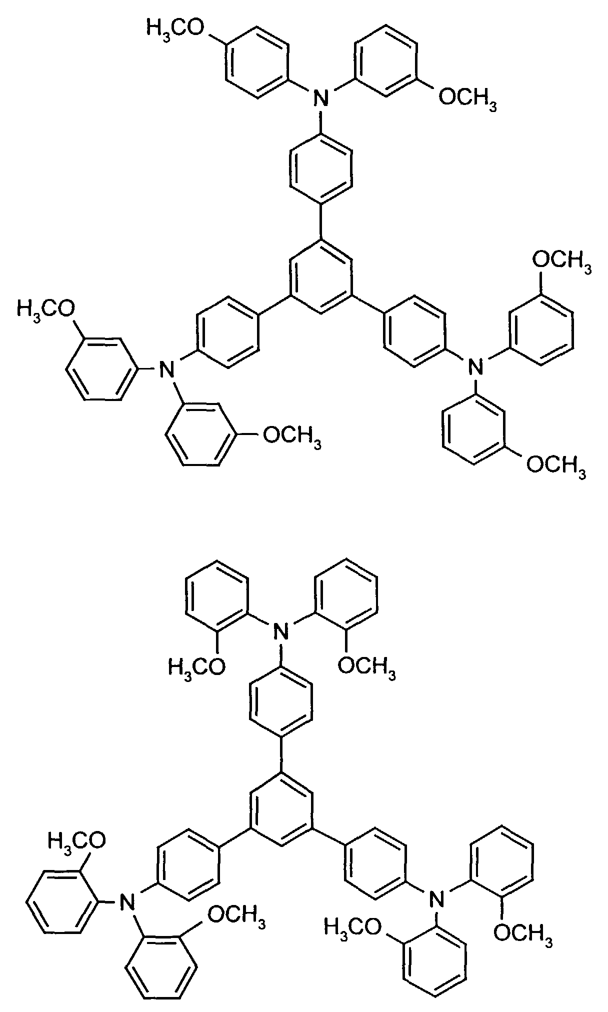

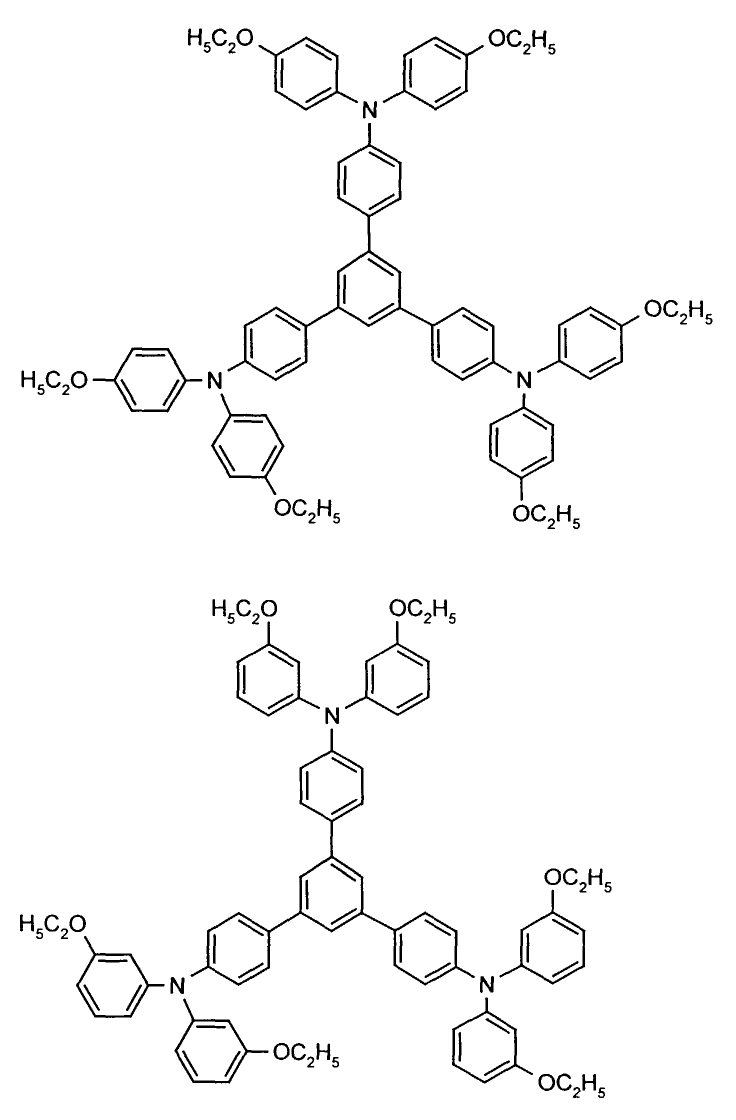

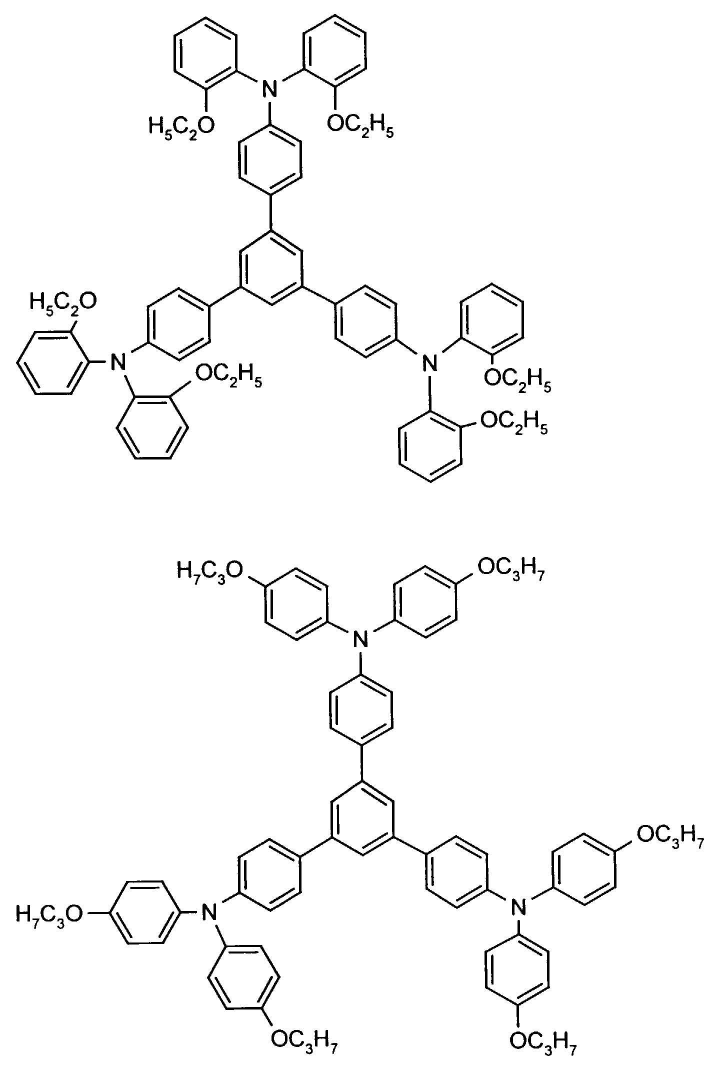

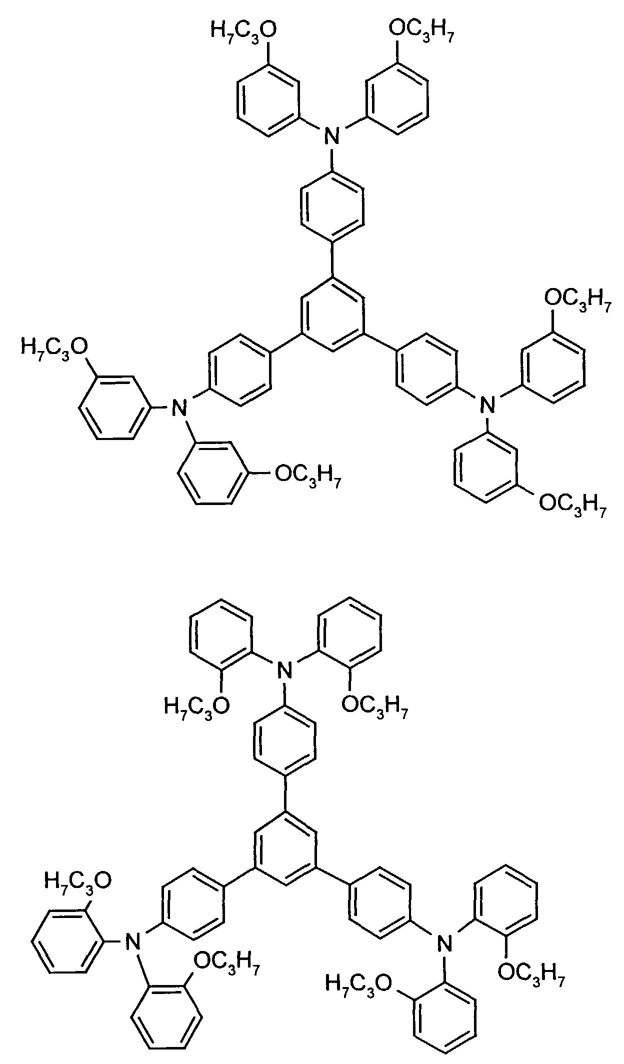

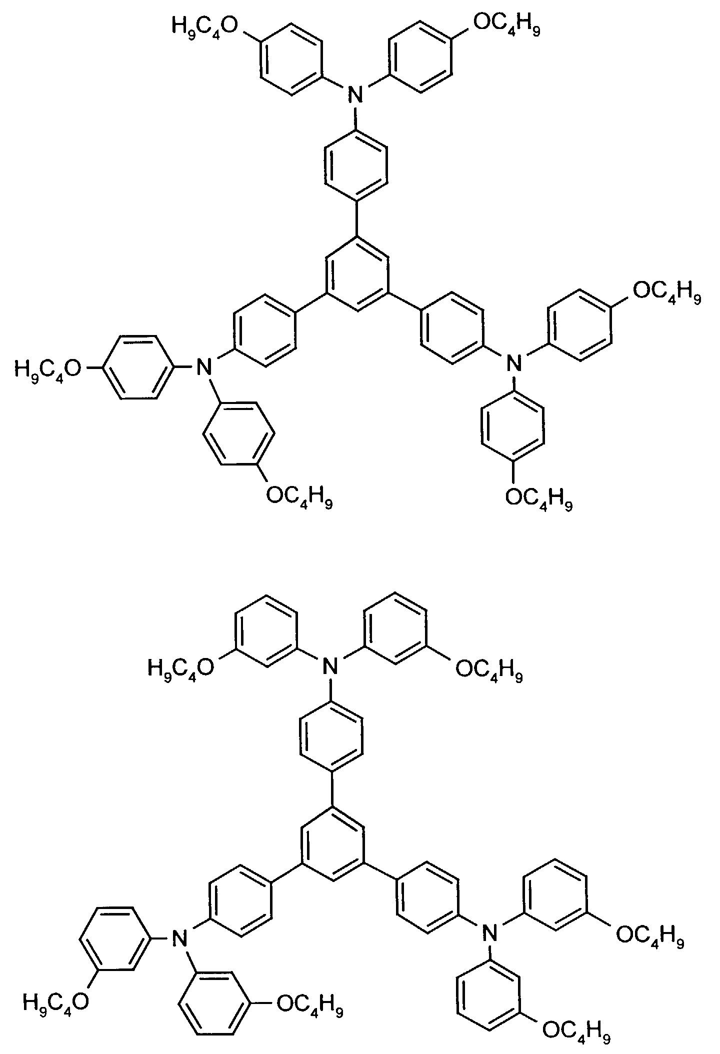

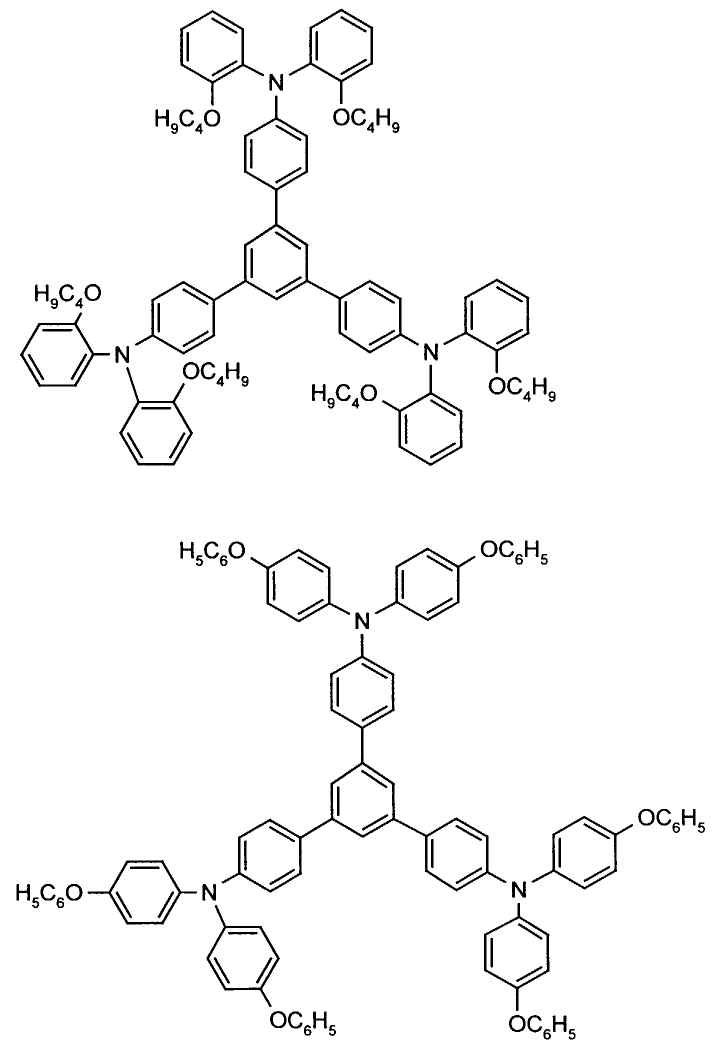

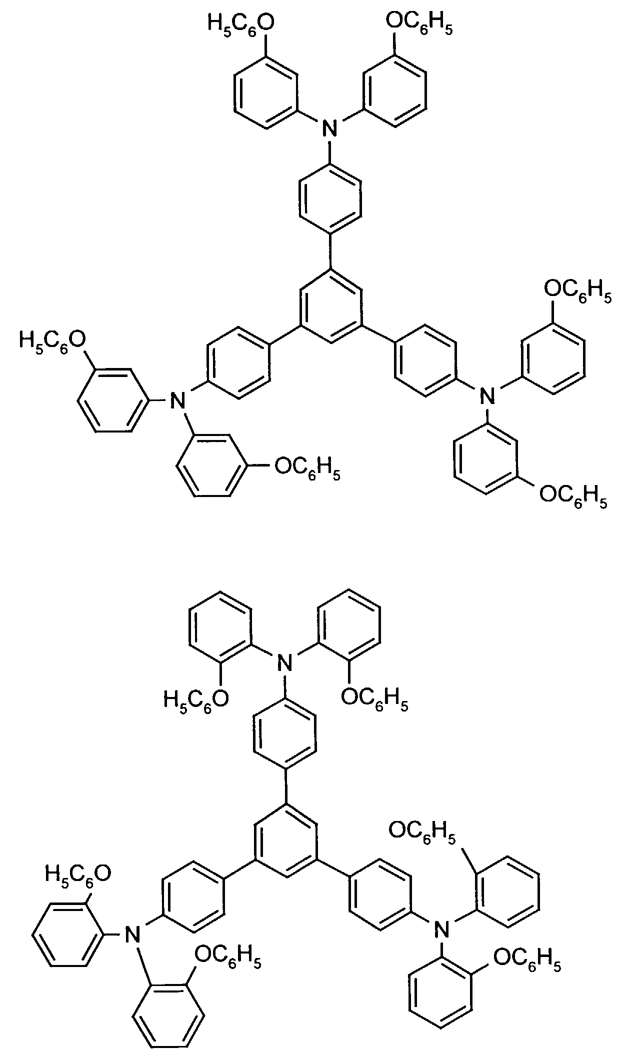

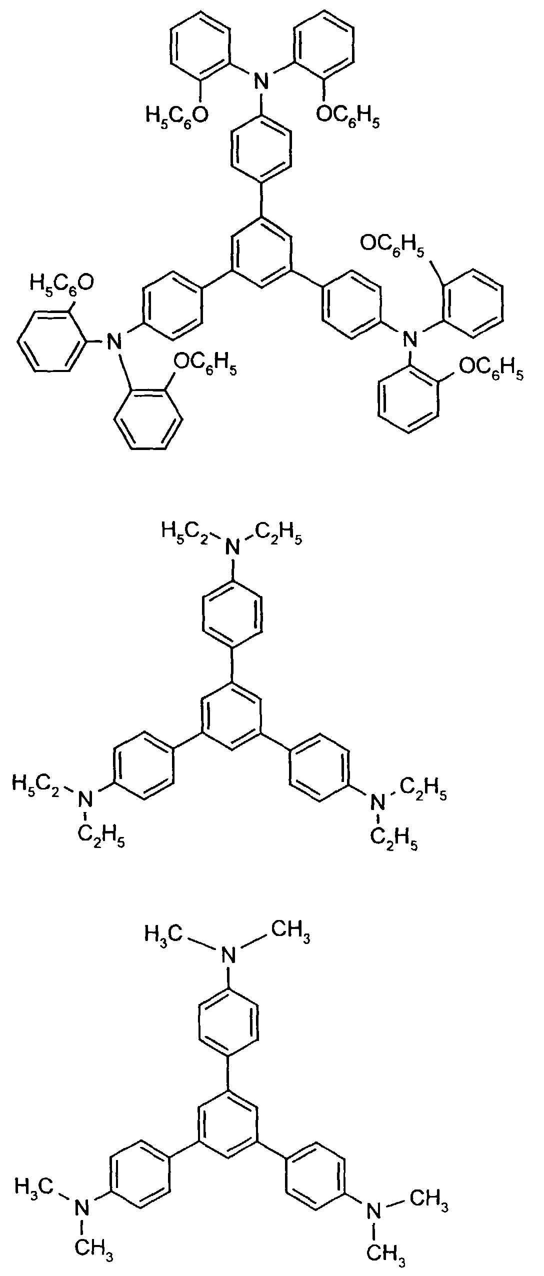

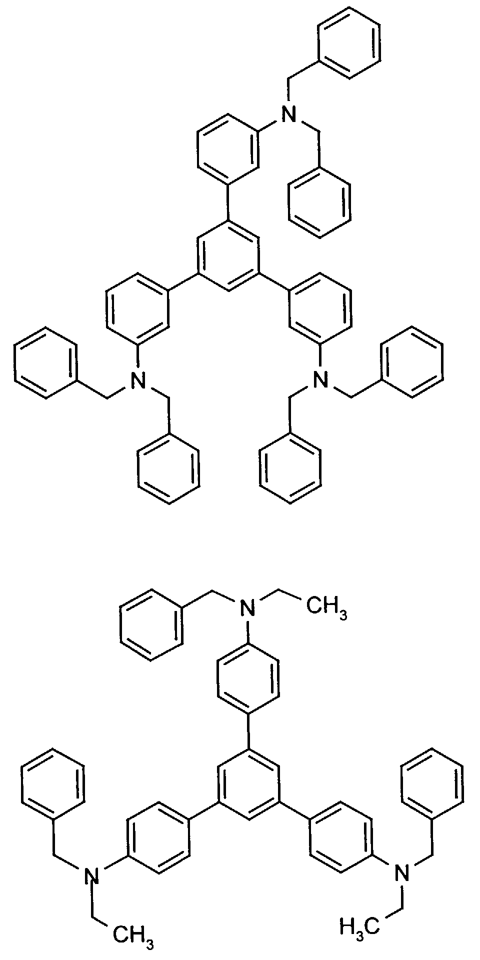

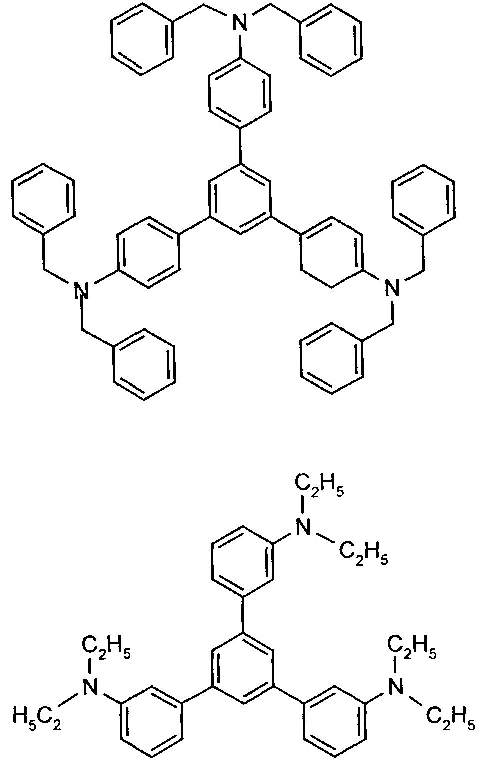

10. Elektrolumineszierende Anordnung gemäß Anspruch 1, dadurch gekennzeichnet, daß der Azomethin-Metallkomplex eine Verbindung der allgemeinen Formel (IIIa) bis (IIIc) ist 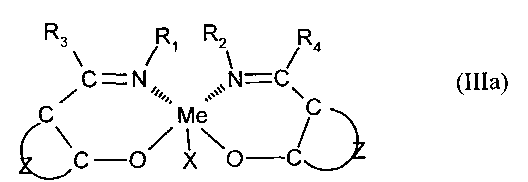 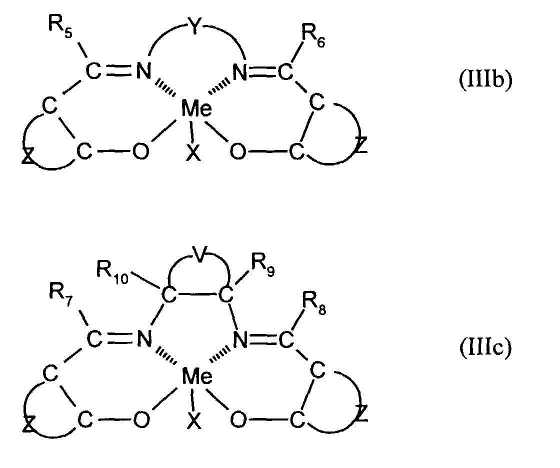 worin
Me für ein Metall steht und
R₁, R₂, R₃, R₄, R₅, R₆, R₇, R₈, R₉ und R₁₀ unabhängig voneinander für Wasserstoff oder einen gegebenenfalls substituierten Alkyl- oder Arylrest stehen,
X für ein Halogenatom und
V, Y, Z für Atome stehen, die einen Kern vervollständigen, der wenigstens jeweils aus einem Ring besteht.

11. Elektrolumineszierende Anordnung gemäß Anspruch 1, dadurch gekennzeichnet, daß der Azomethin-Metallkomplex eine Verbindung der augemeinen Formel (IIId) bis (IIIf) ist 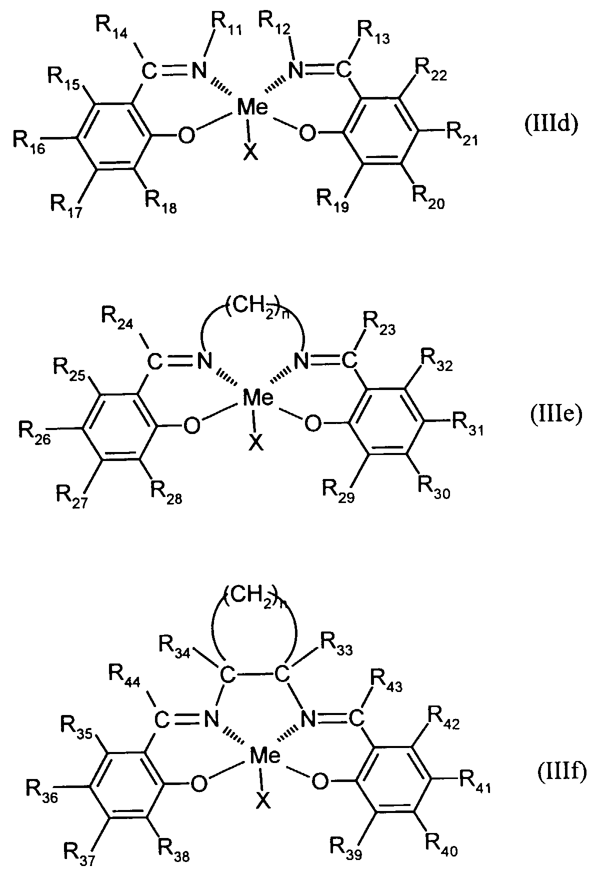 in welcher
X für F, Cl oder Br steht,
R₁₁-R₄₄ unabhängig voneinander für Wasserstoff, gegebenenfalls substituiertes C₁-C₁₆-Alkyl oder Aryl stehen und
n für eine Zahl von 1 bis 10 steht.

12. Elektrolumineszierende Anordnung gemäß Anspruch 10, dadurch gekennzeichnet, daß Me für ein ein-, zwei- oder dreiwertiges Metall steht, das Chelate bildet.

13. Elektrolumineszierende Anordnung gemäß Anspruch 1, dadurch gekennzeichnet, daß sie einen oder mehrere transparente polymere Binder ausgewählt aus der Gruppe Polycarbonate, Polyestercarbonate, Copolymere des Styrols wie SAN oder Styrolacrylate, Polysulfone, Polymerisate auf Basis von Vinylgruppen-haltigen Monomeren, Polyolefine, cyclische Olefincopolymere und Phenoxyharze enthält.

14. Elektrolumineszierende Anordnung gemäß Anspruch 1, dadurch gekennzeichnet, daß der Azomethin-Metallkomplex ausgewählt ist aus den folgenden Verbindungen:
